# EUROPEAN PATENT APPLICATION

(11) **EP 3 842 819 A1**
(43) Date of publication of application: **30.06.2021**
(21) Application number: 19219374.6
(22) Date of filing: 23.12.2019
(51) Int. Cl.: G01R 33/567, G01R 33/48, G01R 33/561, G01R 33/565

(54) **3D MR IMAGING WITH INTRINSIC MOTION DETECTION**

(71) Applicant: Koninklijke Philips N.V., 5656 AG Eindhoven (NL)
(72) Inventor: BECK, Gabriele Marianne, 5656 AE Eindhoven (NL); KRISHNAMOORTHY, Guruprasad, 5656 AE Eindhoven (NL); NAGARAJ, Suthambhara, 5656 AE Eindhoven (NL); KRISHNA, Chennakeshava, 5656 AE Eindhoven (NL); PEETERS, Johannes Martinus, 5656 AE Eindhoven (NL)
(74) Representative: Philips Intellectual Property & Standards

(57) **Abstract**

The invention relates to a method of MR imaging of an object (10) placed in an examination volume of an MR apparatus (1). It is an object of the invention to enable fast 3D MR imaging that provides motion-compensation and also allows a precise compensation for system imperfections. The method of the invention comprises the steps of:
- subjecting the object (10) to a number of shots (S1-S4) of a 3D imaging sequence, wherein a train of MR signals is generated by each shot (S1-S4), each MR signal representing a k-space profile, wherein the set of k-space profiles of each shot (S1-S4) comprises at least one navigator profile and a number of imaging profiles;
- acquiring the MR signals;
- deriving motion information from the at least one navigator profile; and
- reconstructing an MR image from the imaging profiles, wherein a motion-compensation is applied based on the motion information. Motion-induced phase errors can be derived from the navigator profiles, wherein the motion-compensation involves a corresponding phase-correction. Further, phase errors caused by magnetic field gradient imperfections and/or eddy currents can be derived from the navigator profiles and a corresponding phase-correction can be applied during image reconstruction. Moreover, the invention relates to an MR apparatus (1) for carrying out this method as well as to a computer program to be run on an MR apparatus (1).

## Description

### FIELD OF THE INVENTION

The invention relates to the field of magnetic resonance (MR) imaging. It concerns a method of MR imaging of an object. The invention also relates to an MR apparatus and to a computer program to be run on an MR apparatus.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

According to the MR method in general, the object, for example the body of the patient to be examined, is arranged in a strong, uniform magnetic field whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second time constant T₂ (spin-spin or transverse relaxation time). The variation of the magnetization can be detected by means of receiving RF coils which are arranged and oriented within an examination volume of the MR apparatus in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing RF pulse (for example a 180° pulse). This produces an echo signal (spin echo) in the receiving coils.

To realize spatial resolution in the body, constant magnetic field gradients extending along the three main axes are superposed on the uniform magnetic field, leading to a linear spatial dependency of the spin resonance frequency. The signal picked up in the RF receiving coils then contains components of different frequencies which can be associated with different locations in the body. The signal data obtained via the RF receiving coils corresponds to the spatial frequency domain and is called k-space data. The k-space data usually includes multiple profiles (lines) acquired with different phase encoding. Each profile is digitized by collecting a number of samples. A set of k-space data is converted to an MR image by means of an image reconstruction algorithm.

In three-dimensional (3D) stack-of-stars MR imaging (see, e.g., WO 2013/159044 A1), a number of spatially non-selective or slab-selective RF excitations is applied, each followed by the acquisition of a train of MR signals (e.g. gradient echo signals), wherein each MR signal represents a k-space profile. The MR signals are acquired as radial k-space profiles from a number of parallel planes in k-space. In the direction perpendicular to the planes (e.g. the k_{z}-direction) standard Cartesian phase-encoding is performed, while the MR signals are acquired within each single slice along radial 'spokes' that are rotated around the center (kₓ=k_{y}=0). This results in a cylindrical k-space coverage composed of stacked discs ('stack-of-stars'). Technically, this is realized by generating magnetic field gradients in the in-plane directions simultaneously and modulating their amplitudes. Different schemes can be used for selecting the temporal order of the k-space profile acquisition steps. E.g., all phase-encoding steps along the direction perpendicular to the radial k-space profiles can be acquired sequentially before k-space profiles at different angular positions (rotation angles) are acquired. This ensures that periods of Cartesian sampling are kept short, which leads to high data consistency within the stack of planes and preserves the general motion-robustness of radial sampling for the stack-of-stars approach. The Cartesian phase-encoding steps may be performed from the center slice to the k-space periphery (centric out), or in linear order from -k_{z,max} to +k_{z, max}. For the angular ordering, the imaging sequence can use either equidistant angular sampling with multiple interleaves or the so-called golden angle-scheme. In the equidistant scheme, the angular distance, i.e. the increment of the rotation angle of the radial k-space profiles is calculated according to ΔΦ = 180° / nₜₒₜₐₗ where nₜₒₜₐₗ is the total number of k-space profiles per plane. In the golden angle-scheme, the rotation angle of the k-space profiles is incremented each time by ΔΦ = 111.25°, which corresponds to 180° multiplied by the golden ratio. Therefore, subsequently sampled radial k-space profiles always add complementary information while filling the largest gaps within the previously sampled set of profiles. As a consequence, any sequential set of acquired profiles covers k-space approximately uniformly, which, e.g., enables reconstruction of temporal sub-frames and makes the golden-angle scheme also well-suited for dynamic (4D) imaging studies. Moreover, the golden angle scheme reduces temporal coherences in k-space. Thus, motion inconsistencies are spread out in k-space and artefacts are attenuated.

Similarly, in the also known stack-of-spirals acquisition scheme, each non-selective or slab-selective RF excitation is followed by the acquisition of one or more MR signals that represent planar spiral k-space profiles. Like in the stack-of-stars method, standard Cartesian phase-encoding is performed in the direction perpendicular to the planes of the spirals. The MR signals are acquired within each single plane along spiral trajectories having their respective origin or end-point in the k-space center (kₓ=k_{y}=0).

The afore-described 3D radial stack-of-stars and stack-of-spirals schemes offer several promising advantages for clinical 3D and 4D MR imaging like high motion-robustness and benign aliasing artefacts, in particular in combination with a golden angle distribution of k-space profiles.

However, although this intrinsic motion-robustness, the acquired MR images are often still compromised by motion-induced signal fluctuations as long as no additional measures for motion-compensation are applied.

Moreover, MR signal fluctuations caused by system imperfections, like gradient delay and eddy currents have a negative impact on image quality. It is known to apply phase correction for the purpose of compensating for these effects. The phase corrections are derived from adjacent k-space profiles acquired in (approximately) opposite directions. However, the adjacent k-space profiles are typically acquired in completely different motion states of the imaged object during the scan, leading to phase inconsistencies and streaking artefacts.

### SUMMARY OF THE INVENTION

From the foregoing it is readily appreciated that there is a need for an improved MR imaging technique. It is an object of the invention to enable fast 3D MR imaging that provides motion-compensation and also allows a precise compensation for system imperfections.
In accordance with the invention, a method of MR imaging of an object placed in an examination volume of an MR apparatus is disclosed. The method comprises the steps of:
- subjecting the object to a number of shots of a 3D imaging sequence, wherein a train of MR signals is generated by each shot, each MR signal representing a k-space profile, wherein the set of k-space profiles of each shot comprises at least one navigator profile and a number of imaging profiles;
- acquiring the MR signals;
- deriving motion information from the at least one navigator profile; and
- reconstructing an MR image from the imaging profiles, wherein a motion-compensation is applied based on the motion information.

Preferably, each shot comprises at least three navigator profiles oriented in different directions.

The invention enables multi-shot 3D MR imaging with intrinsic shot-to-shot navigation, preferably in three (orthogonal) spatial directions with a corresponding motion-compensation taking motion in all three directions into account. The invention thereby provides a powerful technique for high resolution and low distortion 3D (and 4D) MR imaging.

According to the invention, each shot of the imaging sequence comprises an RF pulse for excitation of transverse nuclear magnetization, with a train of MR signals (e.g. spin echo signals) being generated after each excitation RF pulse. These MR signals are acquired. At least three MR signals (preferably the first MR signals of each shot) constitute navigator profiles oriented in different directions (preferably along the three coordinate axes). The navigator profiles are followed by a number of imaging profiles. A number of such shots are applied for completely sampling k-space in order to be able to reconstruct a full MR image at the required resolution from the acquired imaging profiles. The invention proposes that there are three (or more) navigator profiles acquired in each shot before the acquisition of the imaging profiles. The invention uses these navigator profiles for the derivation of motion information, e.g. by estimating motion-induced phase errors in all three directions, that is later used in the reconstruction step for motion-compensation, e.g. by corresponding phase-correction. Determining the phase-errors in all three directions over the whole scan provides the unique capability to fully correct for motion-induced phase shifts. Optionally, in case the MR signals are acquired via an array of receiving RF coils, only the navigator profiles acquired via a subset of the RF coils may be used for derivation of the motion information, i.e. the motion-induced phase errors, depending on the position and orientation of the RF coils in relation to the (main) direction of the occurring motion. This may improve the quality of the phase-correction.

Optionally, the train of MR signals comprises a number of start-up MR signals generated temporally prior to the MR signals representing the navigator profiles and the imaging profiles respectively. The 3D imaging sequence may be a TFE (turbo fiels echo) sequence, for example, of which each shot comprises an RF pulse for excitation of transverse nuclear magnetization followed by a number of refocusing magnetic field gradients generating the train of MR signals as field echo signals. There may be a certain number of initial start-up echo signals in each shot of the TFE imaging sequence before the actual acquisition of the navigator and imaging profiles respectively so as to allow the echo train to stabilize and to reach a steady state of the transverse nuclear magnetization. The start-up echo signals are not used for navigation or for image reconstruction. In a preferred embodiment of the invention, the set of k-space profiles of each shot comprises one or more pairs of navigator profiles (preferably at least six navigator profiles forming three pairs), wherein the profiles of each pair are oriented in opposite spatial directions. The acquisition of anti-parallel pairs of navigator profiles enables the derivation of phase errors caused by magnetic field gradient imperfections and/or eddy currents and a corresponding phase-correction. Because of the temporally close acquisition of the navigator profiles of each pair, this phase-correction is not negatively affected by motion. The navigator profiles of each pair are acquired during (essentially) the same motion state of the imaged object. Hence, inconsistencies in the phase-correction leading to image artefacts are effectively avoided. The invention thus provides a 3D MR imaging technique with motion-compensation and a precise compensation for imperfections of the used MR apparatus.

In a preferred embodiment, the derivation of motion information from the navigator profiles involves the detection of motion-induced displacements and/or deformations of the object during the acquisition of the MR signals and assigning each of the sets of k-space profiles to a motion state. Therein, each of the motion states corresponds to one of a plurality of contiguous ranges of motion-induced displacements and/or deformations of the object. The frequency of the occurrence of each motion state can be determined to apply a weighting to the k-space profiles in the step of reconstructing the MR image, with a stronger weighting being applied to k-space profiles associated with more frequent motion states and a weaker weighting being applied to k-space profiles associated with less frequent motion states. Hence, the navigator profiles are used in this embodiment to implement a soft gating approach for motion-compensation, i.e. for reducing artefacts caused by motion.

The derivation of motion information from the navigator profiles, in particular for enabling the assignment of the sets of k-space profiles to motion states as described before, may involve the determination of the position of the center of mass of the object from projection images reconstructed from the navigator profiles. The changes of the position of the center of mass of the object reflect motion of the object, such as, e.g. breathing motion or cardiac motion occurring during the MR signal acquisition. Since these motions are known to have different frequencies they can be separated by filtering according to the respective frequency bands. On the basis of the detected breathing motion, e.g., the afore-described soft gating approach can be used to focus the MR image reconstruction on the MR signal data acquired during the most common position taken by the patient during free breathing.

In a further preferred embodiment, the motion information is supplemented by motion data acquired from the object via one or more external motion sensors. For example, a camera or a respiratory belt may be used to increase the precision of determining the momentary motion state during MR signal acquisition. The external motion sensor may be used, e.g., to detect the frequency of the (breathing) motion of the object. The detected frequency can then be used for calculating the band pass-filtered center of mass, as described before.

In yet another preferred embodiment, the MR signals are acquired using a stack-of-stars or stack-of-spirals acquisition scheme as described above. To optimize the k-space distribution of the acquired imaging profiles, the angular ordering of the radial or spiral k-space profiles may be chosen according to a golden angle-scheme. The distribution of rotation angles can be also adapted to anisotropic field of views (see Wu et al. Al, "Anisotropic field-of-view support for golden angle radial imaging, Magn Reson Med., 76, 229-236, 2016), wherein the radial (or spiral) k-space profiles are not equidistantly distributed. Other methods for optimizing the sampling order like, e.g., CENTRA ordering (see WO 2016202707 A1) or Rotated Stack-of-Stars (see Zhou et al., "Golden-ratio rotated stack-of-stars acquisition for improved volumetric MRI", Magn. Reson. Med. 2017) can be combined with the method of the invention.

In further possible embodiments, the MR signals may be acquired using a 3D radial acquisition scheme (also referred to as "kooshball"-type of acquisition, see Stehning et al., Magnetic Resonance in Medicine, vol. 52, p. 197-203, 2004) or a so-called FLORET acquisition scheme (see Pipe et al., Magnetic Resonance in Medicine, vol. 66, p. 1303-1311, 2011).

The method of the invention described thus far can be carried out by means of an MR apparatus including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR apparatus.

The method of the invention can be advantageously carried out in most MR devices in clinical use at present. To this end it is merely necessary to utilize a computer program by which the MR apparatus is controlled such that it performs the above-explained method steps of the invention. The computer program may be present either on a data carrier or be present in a data network so as to be downloaded for installation in the control unit of the MR apparatus.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR apparatus for carrying out the method of the invention;
Fig. 2 shows a diagram k-space illustrating the sampling scheme of the invention;
Fig. 3 shows a diagram illustrating the soft gating scheme adopted according to the invention;
Fig. 4 shows a slice of 3D MR image (left: conventional motion-compensation using a respiratory belt, right: motion-compensation using the intrinsic navigator technique of the invention).

### DETAILED DESCRIPTION OF THE EMBODIMENTS

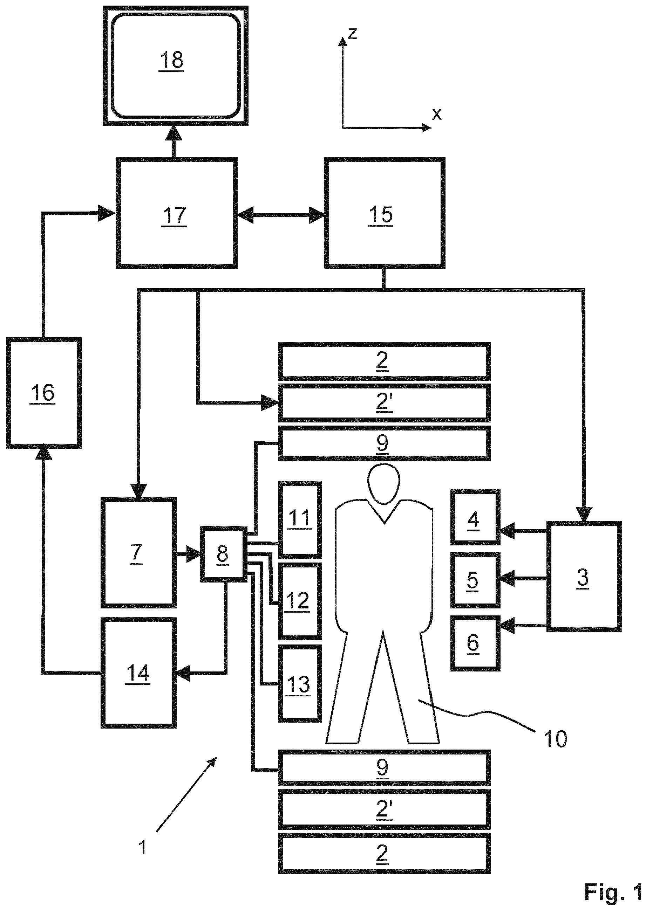

With reference to Fig. 1, an MR apparatus 1 is shown. The apparatus comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the gradient pulse amplifier 3 and the transmitter 7 to generate any of a plurality of MR imaging sequences. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR apparatuses, the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such as SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

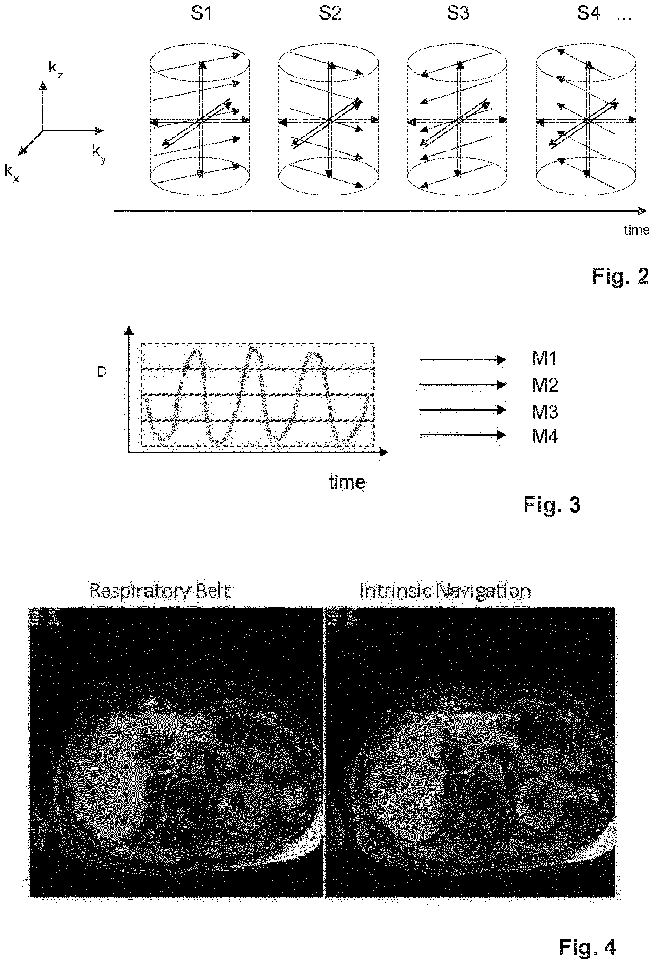

With continuing reference to Fig. 1 and with further reference to Figs. 2, 3, and 4 embodiments of the method of the invention are explained in the following.

The body 10 is subjected to multiple shots of a 3D imaging sequence. The k-space sampling in the first four shots S1-S4 is illustrated in Fig. 2. The imaging sequence may be, e.g., a 3D TFE (turbo field echo) sequence. A train of echo signals is generated in each shot S1-S4, each echo train comprising six navigator profiles (depicted as solid arrows) of which pairs are oriented in opposite spatial directions along the three orthogonal coordinate axes kₓ, k_{y}, k_{z}, followed by a number of imaging profiles (depicted as dashed arrows). The imaging profiles are acquired according to a stack-of-stars scheme as radial k-space profiles from a number (five in the embodiment of Fig. 2) of parallel planes. The planes are arranged at different positions along the k_{z}-direction. Cartesian phase-encoding is performed in the k_{z}-direction, while the radial orientation of the k-space profiles is rotated around the center (kₓ=k_{y}=0) from shot to shot. This results in a cylindrical k-space coverage composed of stacked discs. For the angular ordering of the radial imaging profiles, a golden angle-scheme is employed. Successive acquisition of the phase-encoding steps along the k_{z}-direction is performed before sampling imaging profiles at different golden angular positions which is essential to ensure high data consistency and general motion-robustness.

According to the invention, motion of the examined body 10 is detected by deriving motion information from the navigator profiles. To this end, the center of mass of the object is determined from projection images reconstructed from the navigator profiles. The projection images are reconstructed by Fourier transformation of the navigator profiles to obtain projections of the imaging volume onto the direction of the respective navigator profile. The center of mass of these projections is then determined as the average position weighted by signal intensity. The changes in this intensity-weighted position, i.e. the changes of the position of the center of mass of the object, reflects motion of the object, such as, e.g. breathing motion or cardiac motion occurring during the MR signal acquisition. Since these motions have different frequencies (e.g. 0.1-0.5 Hz for respiratory motion and 0.6-3 Hz for cardiac motion) they can be separated by filtering according to the respective frequency bands.

On the basis of the detected breathing motion, each of the acquired shots S1-S4 can be assigned to a motion (breathing) state. Each of the motion states M1-M4 is defined to correspond to one of a plurality of contiguous ranges of the breathing motion-induced displacement D (see Fig. 3). On this basis, a 3D soft gating approach is implemented by weighting the imaging profiles in the reconstruction of an MR image from the acquired imaging profiles. A stronger weighting is applied to imaging profiles acquired in more frequent motion states M1-M4, while a weaker weighting is applied to imaging profiles in less frequent motion states M1-M4. Imaging profiles acquired with the body 10 assuming its most frequently taken positions during breathing are given a stronger weight while MR signals acquired in rarely assumed positions are suppressed in the reconstructed MR image. The frequency of the occurrence of each motion state M1-M4 as a basis for the weighting can be derived from a histogram. The histogram can be set up during or after MR signal acquisition. It reflects the number of shots per motion state M1-M4. The weighting factors can be derived from the histogram, wherein a user-specified gating percentage is taken into account. The gating percentage defines the proportion of the imaging profiles suppressed by the weighting as a global parameter that can be tuned by the user according to the needs (wherein image noise and artefact level are balanced). When determining the weighting factors, the compliance with the Nyquist criterion must be taken into account in order to avoid aliasing artefacts. In radial k-space sampling schemes, a broader range of weighting factors can be applied to the k-space profiles in the central portion of k-space as compared to the peripheral portions of k-space. The less pronounced weighting in peripheral k-space has the effect that streaking artefacts from k-space sub-sampling can be avoided.

A challenge associated with radial k-space sampling is the imperfect alignment of each sampled k-space profile with the center of k-space (kₓ=k_{y}=0). Eddy currents, gradient imperfections and timing delay errors cause the sampled k-space profiles to shift from the intended trajectory. This shift changes as the readout direction is rotated. Methods exist to align miscentered radial k-space profiles by comparing radial k-space profiles that have (nearly) opposite readout directions. The opposite readout direction causes the shift in k-space to be in opposite directions. Hence, the k-space shift can be determined from the phase differences between acquisitions having opposite readout directions and the acquired MR signal data can be corrected accordingly. The acquisition of anti-parallel pairs of navigator profiles as shown in Fig. 2 thus enables the derivation of the phase differences caused by magnetic field gradient imperfections and/or eddy currents and a corresponding phase-correction in all three directions. Because of the temporally close acquisition of the navigator profiles at the beginning of each shot S1-S4, the phase-correction is not affected by motion. The navigator profiles of each pair are acquired during (essentially) the same motion state of the body 10 such that inconsistencies in the phase-correction leading to image artefacts are effectively avoided.

The result of the intrinsic navigation/phase correction approach of the invention is an MR image reconstructed from a 3D radial acquisition having a low level of artefacts in the presence of motion of the body 10. This can be seen in Fig. 4 showing a slice MR image acquired from the abdominal region using a 3D radial acquisition method. The left image has been acquired and reconstructed conventionally using motion-detection by a respiratory belt and corresponding motion-compensation, while the right image has been reconstructed using the soft gating and phase correction approach of the invention.

## Claims

1. Method of MR imaging of an object (10) placed in an examination volume of an MR apparatus (1), the method comprising the steps of:
- subjecting the object (10) to a number of shots (S1-S4) of a 3D imaging sequence, wherein a train of MR signals is generated by each shot (S1-S4), each MR signal representing a k-space profile, wherein the set of k-space profiles of each shot (S1-S4) comprises at least one navigator profile and a number of imaging profiles;
- acquiring the MR signals;
- deriving motion information from the navigator profiles; and
- reconstructing an MR image from the imaging profiles, wherein a motion-compensation is applied based on the motion information.

2. Method of claim 1, wherein the set of k-space profiles of each shot (S1-S4) comprises at least three navigator profiles oriented in different directions.

3. Method of claim 1 or 2, wherein the motion information is derived from the at least one navigator profile as motion-induced phase errors, wherein the motion-compensation involves a phase-correction according to the motion-induced phase errors.

4. Method of any one of claims 1-3, wherein the set of k-space profiles of each shot (S1-S4) comprises at least one pair of navigator profiles, wherein the navigator profiles of each pair are oriented in opposite spatial directions.

5. Method of claim 4, wherein the reconstruction of the MR image involves deriving phase errors caused by magnetic field gradient imperfections and/or eddy currents from the at least one pair of navigator profiles and a corresponding phase-correction.

6. Method of any one of claims 1-5, wherein a three-dimensional volume of k-space is sampled by the sets of k-space profiles associated with the number of shots of the imaging sequence.

7. Method of any one of claims 1-6, wherein the derivation of motion information from the navigator profiles involves the detection of motion-induced displacements (D) and/or deformations of the object (10) during the acquisition of the MR signals and assigning each of the sets of k-space profiles to a motion state (M1-M4).

8. Method of claim 7, wherein each of the motion states (M1-M4) corresponds to one of a plurality of contiguous ranges of motion-induced displacements (D) and/or deformations of the object (10).

9. Method of claim 7 or 8, wherein the frequency of the occurrence of each motion state (M1-M4) is determined to apply a weighting to the k-space profiles in the step of reconstructing the MR image, with a stronger weighting being applied to k-space profiles associated with more frequent motion states (M1-M4) and a weaker weighting being applied to k-space profiles associated with less frequent motion states (M1-M4).

10. Method of any one of claims 1-9, wherein the derivation of motion information from the navigator profiles involves the determination of the position of the center of mass of the object (10) from projection images reconstructed from the navigator profiles.

11. Method of any one of claims 1-10, wherein the motion information is supplemented by motion data acquired from the object (10) via one or more external motion sensors.

12. Method of any one of claims 1-11, wherein the MR signals are acquired using a stack-of-stars or stack-of-spirals acquisition scheme.

13. Method of claim 12, wherein the rotation angle of the radial or spiral k-space profiles is incremented according to a golden angle scheme during the acquisition of the MR signals.

14. MR apparatus including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR apparatus (1) is arranged to perform the following steps:
- subjecting the object (10) to a number of shots (S1-S4) of a 3D imaging sequence, wherein a train of MR signals is generated by each shot (S1-S4), each MR signal representing a k-space profile, wherein the set of k-space profiles of each shot comprises at least one navigator profile and a number of imaging profiles;
- acquiring the MR signals;
- deriving motion information from the at least one navigator profile; and
- reconstructing an MR image from the imaging profiles, wherein a motion-compensation is applied based on the motion information.

15. Computer program to be run on an MR apparatus (1), which computer program comprises instructions for:
- executing a number of shots (S1-S4) of a 3D imaging sequence, wherein a train of MR signals is generated by each shot (S1-S4), each MR signal representing a k-space profile, wherein the set of k-space profiles of each shot (S1-S4) comprises at least one navigator profile and a number of imaging profiles;
- acquiring the MR signals;
- deriving motion information from the at least one navigator profile; and
- reconstructing an MR image from the imaging profiles, wherein a motion-compensation is applied based on the motion information.
